# EUROPÄISCHE PATENTANMELDUNG

(11) **EP 0 521 189 A1**
(43) Veröffentlichungstag der Anmeldung: **07.01.1993**
(21) Anmeldenummer: 91111242.3
(22) Anmeldetag: 05.07.1991
(51) Int. Cl.: H01L 31/048, H01L 31/02

(54) **Elektrisches Anschlusselement für ein Solarmodul**

(71) Anmelder: Siemens Solar GmbH, D-80807 München (DE)
(72) Erfinder: Riermeier, Manfred, W-8059 Oberneuching (DE); Zinke, Gerhard, Dipl.-Phys., W-8000 München 81 (DE); Münzer, Adolf, Dipl.-Phys., W-8000 München 80 (DE)
(74) Vertreter: Fuchs, Franz-Josef, Dr.-Ing.

(57) **Zusammenfassung**

Eine einfache Anschlußmöglichkeit für ein Solarmodul besteht aus einem angelöteten bolzenförmigen Anschlußelement 5, welches mittels eines übersteckten und mit der Rückseite des Solarmoduls verklebten Halterungselementes fixiert ist. Das Herausragen der Ende des Anschlußelementes weist eine Anschlußmöglichkeit für ein Anschlußkabel auf.

## Beschreibung

Solarmodule bestehen im wesentlichen aus einem Substrat, auf dem mehrere streifen- oder scheibenförmige Solarzellen angeordnet und elektrisch miteinander verschaltet sind. Zum Schutz vor Witterungseinflüssen werden die Solarzellen in ein Kunststoffmaterial eingebettet. Auf der Frontseite dieses Verbundes kann eine Glasscheibe als Substrat dienen. Die Rückseite des Verbundes kann durch eine spezielle zusätzliche Verbundfolie oder durch eine zweite Glasscheibe geschützt werden. Zur besseren Handhabung, zur Befestigung und zur Erhöhung der Bruchfestigkeit kann noch ein üblicherweise aus Metall bestehender Rahmen vorhanden sein.

Zur Ableitung des in der Solarzelle bei Sonneneinfall erzeugten Stromes bzw. zur Zusammenschaltung mehrerer Solarmodule sind an diesem elektrische Anschlüsse vorgesehen. Dies können beispielsweise am Modul befestigte Anschlußkästen sein, in deren Innerem die entsprechenden Anschlüsse in Form von Kabelklemmen oder Schraubbolzen vorgesehen sind. Als weitere Anschlußmöglichkeiten sind zum Beispiel fest am Rahmen montierte Anschlußbolzen oder im Modul fest eingebaute Anschlußkabel bekannt.

Nachteilig an den bekannten elektrischen Anschlüssen für Solarmodule ist deren relativ hoher Material- und Herstellungsaufwand, der einen nicht unwesentlichen Kostenfaktor des gesamten Solarmoduls darstellen kann.

Aufgabe der vorliegenden Erfindung ist es daher, ein Solarmodul mit einem einfach herzustellenden elektrischen Anschluß anzugeben, welcher außerdem eine einfache, schnelle und sichere Verschaltung gewährleistet.

Diese Aufgabe wird erfindungsgemäß gelöst von einem Solarmodul, welches zumindest zwei elektrische Anschlüsse aufweist, die aus je einem bolzenförmigen Anschlußelement bestehen, das mit Hilfe eines übergesteckten, auf der Rückseite des Moduls aufgeklebten Halterungselementes fixiert ist. Weiterhin liegt es im Rahmen der Erfindung, daß das Halterungselement aus Kunststoff besteht.

Weitere Ausgestaltungen der Erfindung sind den Unteransprüchen zu entnehmen.

Der elektrische Anschluß für das erfindungsgemäße Solarmodul kann in einfacher Weise an beliebiger Stelle des Moduls angebracht werden. Das Halterungselement sorgt für einen sicheren Halt des Anschlußelementes, da es dieses teilweise umschließt und mit seinem verbreiterten Fuß genügend Auflagefläche zur sicheren Verklebung auf dem Modul bereitstellt. Das Anschlußelement selbst braucht nur an die Leiterbänder angelötet zu werden, die dazu an einer Stelle auf die Rückseite des Moduls geführt werden müssen. Das Halterungselement weist zentral eine dem bolzenförmigen Anschlußelement angepaßte Bohrung auf, so daß bereits durch das Aufstecken des Halterungselements ein guter Halt des Anschlußelements auch ohne Verkleben gewährleistet ist. Ein aus Kunststoff gefertigtes Halterungselement ist gleichzeitig elektrisch isolierend und versiegelt bei geeigneter Verklebung die zum elektrischen Anschluß erforderliche Öffnung im zum Beispiel laminierten Solarmodul.

Eine weitere vorteilhafte Ausgestaltung der Erfindung sieht ein zumindest teilweise hohles Halterungselement vor, dessen Hohlräume beim Verkleben mit Klebstoff vergossen werden, so daß eine besonders dichte und sichere Halterung des Anschlußelements am Modul gewährleistet ist.

In einer weiteren Ausgestaltung der Erfindung ist vorgesehen, eine Schutzdiode in den elektrischen Anschluß zu integrieren. Die Schutzdiode kann beispielsweise mit dem Anschlußelement aufgelötet und unter dem Halterungselement sicher abgedeckt werden.

Das Anschlußelement ist bolzenförmig und kann einen kreisförmigen, eckigen oder kreissegmentförmigen Querschnitt aufweisen. Ein nicht kreisförmiger Querschnitt findet in einem entsprechend geformten Halterungselement einen sichereren Halt, so daß ein Abriß des Anschlußelements, beispielsweise durch Abdrehen von der Lötstelle vermieden wird.

Das Anschlußelement weist in seinem oberen, aus dem Halterungselement herausragenden Teil eine Ausgestaltung auf, die zum sicheren und einfachen Anschließen eines Anschlußkabels geeignet ist. Beispielsweise kann das Anschlußelement im oberen Teil ein Gewinde aufweisen, so daß ein elektrischer Anschluß mit Hilfe eines Kabelschuhs, Überwurfmuttern und Federringen bewerkstelligt werden kann. Eine weitere Anschlußmöglichkeit ist gegeben, wenn das Anschlußelement in seinem oberen Teil als Klemmverbindung ausgebildet ist. Auch ist es möglich, den elektrischen Anschluß über eine Steckverbindung herzustellen, wobei das Anschlußelement als Buchse oder Stecker ausgebildet ist. Weiterhin ist es möglich, den elektrischen Anschluß über eine Kombination von Anschlußmöglichkeiten herzustellen, beispielsweise über eine Steckverbindung, die durch eine zusätzliche Verschraubung gesichert ist.

Eine weitere Ausgestaltung der Erfindung betrifft eine Vorrichtung zum Schutz des elektrischen Anschlusses vor Feuchtigkeit und Niederschlägen. Nach dem Herstellen eines elektrischen Anschlusses kann dieser beispielsweise durch eine Batterieschutzkappe oder eine ähnliche Vorrichtung abgedeckt bzw. abgedichtet werden. Die Schutzkappe ist zum Aufstecken auf das Halterungselement geeignet, wobei das Anschlußelement bzw. der elektrische Anschluß unter der Schutzkappe abgedeckt wird. Die Schutzkappe kann Teil des Anschlußkabels sein, dessen zum Anschluß an das Anschlußelement vorgesehenes Ende im Inneren der Schutzkappe mündet.

Zum sicheren Befestigen der Schutzkappe auf dem Halterungselement können auf vom Anschlußelement wegweisenden Seiten des Halterungselementes Vorrichtungen zum Einrasten der Schutzkappe vorgesehen sein, beispielsweise eine Ausnehmung oder eine entsprechend vorspringende Nase. Ausnehmung oder Nase können durchgehend über den ganzen Umfang des Halterungselementes ausgebildet sein und so eine ringförmige Nut oder Wulst darstellen. Wenn Halterungselement oder Schutzkappe entsprechend elastisch sind, läßt sich so eine ausreichend wasserdichte und gut sitzende Abdeckung des elektrischen Anschlusses herstellen.

In einer Ausführung der Erfindung können mehrere elektrische Anschlüsse nebeneinander vorgesehen sein. Dabei ist es möglich, für zwei Anschlußelemente ein gemeinsames Halterungselement vorzusehen. Es muß nur gewährleistet sein, daß sich die elektrischen Anschlüsse getrennt voneinander herstellen lassen.

Pro Modul müssen zumindest zwei elektrische Anschlüsse vorgesehen sein. Doch ist es auch möglich, zumindest einen weiteren Anschluß vorzusehen, mit dessen Hilfe sich eine geringere als die Maximalspannung am Modul abgreifen läßt.

Im folgenden wird die Erfindung anhand von Ausführungsbeispielen und der dazugehörigen vier Figuren näher erläutert. Dabei zeigen
- die Figuren 1 und 2: im schematischen Querschnitt die Herstellung des elektrischen Anschlusses eines Solarmodules und
- die Figuren 3 und 4: verschiedene Ausgestaltungen des Anschlußelements, ebenfalls im schematischen Querschnitt.

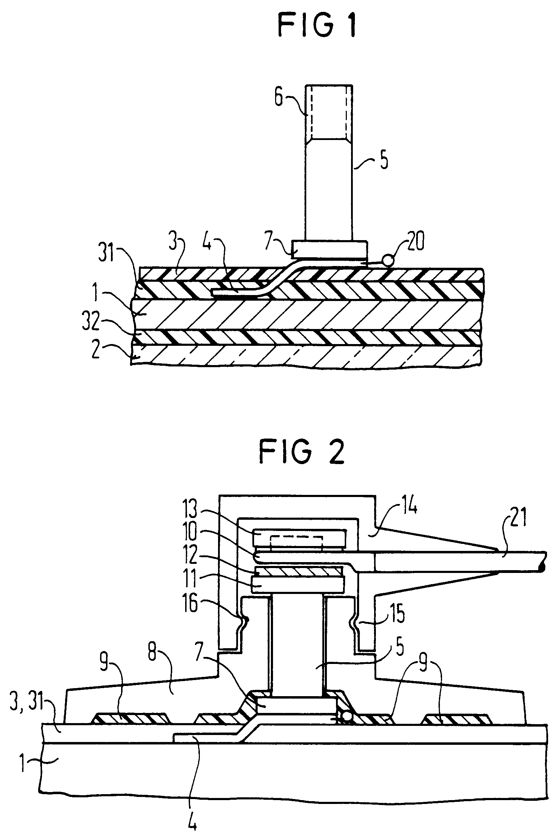

Figur 1: Das Solarmodul besteht aus mehreren kristallinen Solarzellen 1, die zwischen Kunststoffolien (31, 32) eingebettet werden. Als Substrat 2 dient auf der Frontseite eine Glasscheibe. Der rückseitige Schutz wird durch eine mehrlagige Verbundfolie 3 gewährleistet. Die Solarzellen 1 sind beispielsweise durch entsprechend aufgelötete Leiterbändchen elektrisch verschaltet. An zumindest zwei Stellen des Moduls werden die Leiterbändchen 4 durch die abdeckende Ver-bundfolie 3 auf die Rückseite des Moduls geführt. Auf diese Enden der Leiterbändchen 4 wird nun ein Anschlußelement 5 aufgelötet. Dieses weist zum Beispiel die Form eines Zylinders auf, kann einen verbreiterten Fuß 7 besitzen und an seinem oberen Ende ein Gewinde 6 aufweisen. Die Figur zeigt das angelötete Anschlußelement 5, daneben die ebenfalls angelötete Schutzdiode 20.

Figur 2: Auf das Anschlußelement 5 wird ein aus Kunststoff bestehendes Halterungselement 8 gesteckt, welches dazu eine entsprechend dem Anschlußelement 5 geformte Durchführung aufweist. In vorteilhafter Weise ist das Halterungselement 8 wie dargestellt an seinem Fuß verbreitert, um eine sichere Auflagefläche auf dem Solarmodul zu gewährleisten. Seine größte Höhe weist es rund um das Anschlußelement 5 auf, um diesem einen sicheren Halt zu geben. Die Auflagefläche des Halterungselements kann plan ausgeführt sein, oder wie dargestellt verschiedene Ausnehmungen besitzen, die beim Aufkleben auf die Rückseite des Solarmoduls mit Klebstoff 9 aufgefüllt werden. Im Ausführungsbeispiel ist das Halterungselement 8 aus Polycarbonat ausgebildet und wird mit einem Silikonkleber auf der Verbundfolie 3 aufgeklebt.

In der Figur 2 ist bereits ein elektrischer Anschluß mit Hilfe eines Anschlußkabels 21 hergestellt. Dieses endet in einem Kabelschuh 10, welcher über das aus dem Halterungselement 8 herausragende Teil des Anschlußelements gesteckt wird. Dort ist es zwischen einer ersten aufgeschraubten Gegenmutter 11 einem Federring 12 und einer weiteren aufgeschraubten Überwurfmutter 13 befestigt. Nur schematisch dargestellt ist die Batterieschutzkappe 14, die mit dem Anschlußkabel 21 verbunden ist und auf das Halterungselement 8 aufgesteckt werden kann. Eine Nase 15 am unteren Ende der Batteriekappe kann in eine Nut 16 des Halterungselements 8 einrasten und so sicher mit diesem verbunden werden. Der elektrische Anschluß wird so wasserdicht von der zum Beispiel aus Hartgummi bestehenden Batterieschutzkappe 14 abgedeckt.

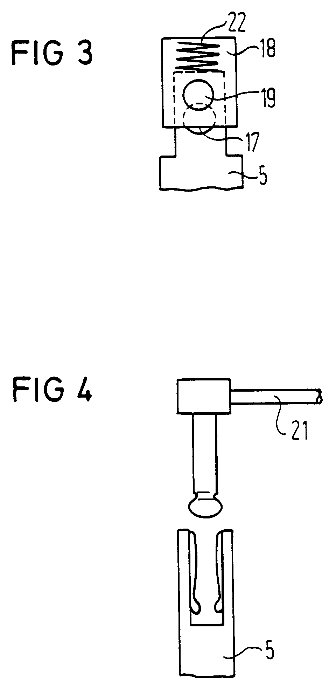

In Figur 3 ist eine weitere Variante eines Anschlußelements 5 dargestellt, dessen oberes Ende eine Klemmverbindung zum Anschluß eines Kabels aufweist. Diese besteht im wesentlichen aus einer quer zur Achse des Anschlußelements 5 geführten Bohrung 17 und einer über das Anschlußelement 5 gestülpten Hülse 18, welche eine gleiche Bohrung 19 aufweist. Die Hülse 18 ist auf dem Anschlußelement 5 zumindest soweit verschiebbar, daß sich in der einen Stellung die Bohrungen 17 und 19 vollständig überlappen, während in der anderen Stellung nur noch eine geringe Überlappung der beiden Bohrungen besteht. Eine Feder 22 kann die Hülse 18 in der letzten Stellung fixieren. Gegen den Federdruck wird die Hülse 18 nun soweit verschoben, daß ein Anschlußkabel durch die nun überlappenden Bohrungen geführt werden kann. Nach Entlastung der Feder 22 verschiebt sich die Hülse 18 wieder, so daß das Kabelende zwischen den nicht mehr vollständig überlappenden Bohrungen von Hülse und Anschlußelement 5 fixiert ist. In dieser Stellung kann die Hülse 18 durch eine (nicht eingezeichnete) auf dem Anschlußelement 5 aufgeschraubte Mutter fixiert werden. Dabei kann gegebenenfalls auch auf die Feder verzichtet werden.

Figur 4 zeigt das obere Ende eines als Steckerbuchse ausgebildeten Anschlußelementes 5 sowie ein mit einem entsprechenden Stecker versehenes Anschlußkabel.

## Patentansprüche

1. Solarmodul, welches zumindest zwei elektrische Anschlüsse aufweist, die aus je einem bolzenförmigen Anschlußelement (5) bestehen, das mit Hilfe eines übergesteckten, auf der Rückseite des Solarmoduls aufgeklebten Halterungselementes (8) fixiert ist.

2. Solarmodul nach Anspruch 1, **dadurch gekennzeichnet,** daß das Halterungselement (8) aus Kunststoff besteht.

3. Solarmodul nach Anspruch 1 oder 2, **dadurch gekennzeichnet,** daß das Halterungselement zumindest teilweise hohl ist, wobei die Hohlräume durch einen Klebstoff (9) dicht vergossen sind.

4. Solarmodul nach einem der Ansprüche 1 bis 3, **dadurch gekennzeichnet,** daß in den elektrischen Anschluß eine Schutzdiode (20) integriert ist.

5. Solarmodul nach einem der Ansprüche 1 bis 4, **dadurch gekennzeichnet,** daß zumindest ein Teil des über das Halterungselement (8) herausragenden Anschlußelementes (5) ein Gewinde (6) aufweist.

6. Solarmodul nach einem der Ansprüche 1 bis 4, **dadurch gekennzeichnet,** daß der über das Halterungselement (8) herausragende Teil des Anschlußelementes (5) eine Steckverbindung oder eine Klemmvorrichtung aufweist.

7. Solarmodul nach mindestens einem der Ansprüche 1 bis 6, **dadurch gekennzeichnet,** daß das Halterungselement (8) an den vom bolzenförmigen Anschlußelement (5) wegweisenden Seiten eine zum Einrasten eines weiteren übergesteckten Teiles (14) geeignete Ausnehmung (16) oder eine Nase (15) aufweist.

8. Solarmodul nach mindestens einem der Ansprüche 1 bis 7, **dadurch gekennzeichnet,** daß für zwei Anschlußelemente (5) ein gemeinsames Halterungselement vorgesehen ist.
